# EUROPEAN PATENT SPECIFICATION

(11) **EP 4 195 236 B1**
(45) Date of publication and mention of the grant of the patent: **21.02.2024**
(21) Application number: 22212183.2
(22) Date of filing: 08.12.2022
(51) Int. Cl.: H01J 37/34, C23C 14/35

(54) **MAGNETRON SPUTTERING APPARATUS WITH A MOVABLE MAGNETIC FIELD AND METHOD OF OPERATING THE MAGNETRON SPUTTERING APPARATUS**
MAGNETRON-ZERSTÄUBUNGSGERÄT MIT BEWEGLICHEM MAGNETFELD UND VERFAHREN ZUM BETRIEB DES MAGNETRON-ZERSTÄUBUNGSGERÄT
APPAREIL DE PULVÉRISATION MAGNÉTRON À CHAMP MAGNÉTIQUE MOBILE ET PROCÉDÉ DE FONCTIONNEMENT DE L'APPAREIL DE PULVÉRISATION À MAGNETRON

(30) Priority: 09.12.2021 DE 102021132580
(43) Date of publication of application: 14.06.2023
(73) Proprietor: Platit AG, 2545 Selzach (CH)
(72) Inventor: JILEK, Mojmir, 78701 Sumperk (CZ); ZEMLICKA, Radek, 2545 Selzach (CH); LÜMKEMANN, Andreas, Dr., 3294 Büren a. A. (CH)
(74) Representative: Winter, Brandl - Partnerschaft mbB

(56) References cited:
- EP-A1- 0 284 145
- EP-A1- 2 485 241
- DE-A1- 4 342 766
- GB-A- 2 473 656
- US-B1- 6 436 252

## Description

The present invention relates to a magnetron sputtering apparatus according to the preamble of the independent claim, in particular a magnetron sputtering apparatus for coating a substrate, preferably with AlCr, AlTi, Ti, or ta-C based sputter targets for AlCrN, AlTiN, TiN or ta-C based thin film preparation.

Physical vapor deposition (PVD) includes a variety of vacuum deposition methods, which are used in the manufacture of items, which require thin films for mechanical, optical, chemical or electronic functions. This involves ejecting material from a "target" onto a "substrate". In detail, material is vaporized from a target by a high-power electric arc, by heat or by high-energy particles. The vaporized material then condenses on the substrate, forming a thin film on the substrate. Among those methods, sputtering or sputter deposition is a well-known technique.

In a typical sputtering deposition process, a chamber is first evacuated to high vacuum. Then, sputtering gas such as Argon or Xenon is supplied to the chamber. To initiate plasma generation, high voltage is applied between the cathode and the anode, e.g. formed by the chamber as electrical ground. Electrons which are present in the sputtering gas are accelerated away from the cathode causing collisions with nearby atoms of sputtering gas. These collisions cause ionization. Once the plasma is ignited, the electric field is shielded by the plasma itself. Then, the electrons emitted from the cathode surface are accelerated by so called plasma sheet and their collisions with the neutral gas is source for further ionization.

Magnetron sputter deposition provides several advantages. It does not require melting and heat evaporation of the source material. That is, nearly all materials can be deposited by magnetron sputtering regardless of their melting temperature, and films of alloys and compounds can be deposited while maintaining similar composition to that of the target material.

In US 6,436,252 B1, a cathode assembly for magnetron sputtering of a workpiece, and a sputtering apparatus and methods of sputtering using the same are described. The cathode assembly includes a tubular cathode, which may be cylindrical in cross section along its length, or which may be curved or flexible, depending on the shape of workpiece to be sputtered, and which has a sputtering length of Ls. The cathode assembly also includes a magnet package, or a plurality of spaced magnet packages, each magnet package including either one magnet or a plurality of spaced magnets of alternating polarity. Furthermore, the magnet package is held within the cathode for shuttle movement, which allows for variations of one or more of the magnet package length, number, and spacing, and the relative displacement distance or shuttle distance, in order to tailor the erosion profile along the axis of symmetry of the cathode. By this approach, the target erosion can be kept uniform. However, in this known cathode assembly all the magnets must have the same field strength in order to be able to control ionisation. Therefore, it is difficult to produce surface coatings with certain coating properties like fine crystal stucture with small grain sizes and high density of the resulting thin film. Further known magnetron sputtering assemblies or cathodic arc deposition sources with movable magnetic field generation devices are disclosed in GB 2473656 A, DE 4342766 A1, EP 0284145 A1, and EP 2485241 A1.

Economical magnetron sputtering takes advantage of the above phenomena by using very strong magnets to confine the electrons in the plasma at or near the surface of the target. Confining the electrons leads to a higher density plasma and improved physical properties of the sputtered layer.

Higher power densities, in particular enhanced sputter power densities on the sputter target surfaceare expected to lead to higher plasma ionization. But the target (consumable part of the cathode) tends to melt as the power density gets too high.

In view of the above, it is the object of the present invention to provide a magnetron sputtering apparatus, which allows a higher plasma ionization and improved physical properties of the sputtered layer while keeping the expenditure for reconstructing the apparatus at the lowest possible level.

This object is solved by a magnetron sputtering apparatus as defined in the independent claim.

According to an aspect of the present disclosure a magnetron sputtering apparatus, which may be used for coating of a substrate, comprises: a treatment chamber to be evacuated and then to be supplied with a sputtering gas; substrate holding means for holding a substrate; a cathode, an anode and a power supply for applying high voltage between the cathode and the anode; a target forming the cathode or being supported by the cathode, facing the substrate and being subject to sputtering by plasma formed within the treatment chamber; at least one magnet or other magnetic field generation device forming a magnetic field so as to confine electrons in the plasma at or near a surface of the target; and moving means for moving the at least one magnet or magnetic field generation device in an axial direction of the target.

It was found that for raising the allowable power density into spheres that substantially increase the metal ionization rates, it is decisive not only to use strong magnets but to appropriately design the magnetic field, i.e. not only the strength but also its form, which leads to a specific relationship of mean and maximum power densities at the target surface. In more detail, the magnetic field generation device is constructed as a set of three aligned permanent magnets, which co-operate, wherein a center magnet is oppositely poled to and magnetically stronger than the side magnets. This concept is based on the effect of sandwiching a main magnet between two auxiliary magnets, which allows to influence the field lines of the main center magnet. In detail, the field lines of the main magnet are condensed in an axial direction. By such arrangement the magnetic field is axially concentrated to a single a slim area at the center magnet for allowing there at or near the target surface the generation of peak power densities above 500 W/cm², also in view of the fact that the magnetic field influences the electric field. By this, whilst three magnets are active, the power density follows a single peak curve so that the plasma is stabilised at a single spot. This concentration of the magnetic field stabilizing the plasma is allowed since it is combined with a specific movement of the magnetic field and thus of the plasma, preferably in the range of 0,3 to 1 m/s, which - when using targets of about 500 mm length - corresponds to an oscillation frequency of 0,3 to 1 Hz. Consequently, the thin film deposition can be more accurately controlled, since the plasma is present only at a single spot defining the sputtering space. Moreover, since the maximum of the power density is restricted to a slim area the temperature of the target can be more easily kept within a controllable range even with power densities above 1 kW/cm², which so far could not be realized without melting the target. Namely, instead of vaporizing the target at such slim spot area of the strong magnetic field, due to the movement of the magnet system the effective vaporizing area is increased so that the target is protected from melting. Also, besides an efficient use of energy, such configuration leads to a narrower wear profile, i.e., a slimmer race track on the target, thus facilitating a uniform and balanced controlled consumption of the target.

In this context, it turned out that it is not so important how strong the magnets are. The decisive characteristic is to be seen in the form of the active magnetic field, i.e. in a sharp border line of the magnetic field produced by the magnetic field generation device. Thus, compared to three equally strong magnets, the overall strength of the magnets used in the magnetic field generation device according to the invention can be even reduced.

It follows from the above that moving the magnetic field generation device and thus the magnetic field relatively to the target allows to run a magnetron sputtering process with power densities that would otherwise melt the target (i.e., the consumable part of the cathode). In such configuration, power densities up to 1 kW/cm² or even higher can be used. Higher power densities are expected to lead to locally increased sputtering rates at particular places on the target. Further the higher plasma and power densities are expected to lead to higher ionization of the sputtered material. Each ion bringing significant kinetic and potential energies to the film growth process and consequentially improve the coating properties. Thus, the magnetron sputtering apparatus according to the invention uses a localized and moving magnetic field to achieve high power density and ionization. In contrast, other magnetron sputtering apparatuses uses high but short energetic pulses. The advantage of the solution according to the invention is that no expensive power supply is needed and that the magnetron sputtering apparatus is more robust, in particular, in terms of sensitivity to process parameters and in terms of no need to optimize frequencies duty cycles etc, and thus, the magnetron sputtering apparatus according to the invention is more suitable for the industrial use.

Summing up, with the new technology as claimed a higher energy density, i.e. energy per deposited atom, can be reached in the deposition process, which can be used for improving the properties of the deposited layer or coating, in particular density, crystal structure and/or grain size.

A convenient way of designing the magnetic field generation device such that the above-described magnetic field can be established is to make all magnets of the magnetic field generation device of the same magnetic material, and to make the center magnet is thicker than the side magnets. This allows to control the counter-acting magnetic fields simply by using geometry as control parameter.

Construction space can be optimized, however, if the materials of the magnets are selected such that the center magnet is made of a magnetically stronger material than the side magnets.

The sputter target in use may for instance be made of AlCr, AlTi, Ti, C, TiB2 to make The AlCrN, AlTiN, TiN, and Ta-C coatings.

The sputtering gas may be Ar, Xe and/or N₂ The Ar partial pressure may be in the range from 0.1 Pa to 1 Pa or even up to 2Pa or 3Pa. The N₂ partial pressure may be in the range from 0.05Pa to 0.3Pa. Further, the sputtering gas may be composed by a working gas, in particular, any inert noble gas, preferably Argon, and a reactive gas, in particular, oxygen, nitrogen or acetylene. The working gas does not bond with the coating, but mainly serves to ensure that the ions of the working gas bombard and sputter the cathode/target. The reactive gas is supposed to bond with the coating. Preferably, a partial pressure of the reactive gas may be equal to or less than 0.3 of a total pressure in the treatment chamber in order to avoid bad coating properties.

The voltage applied between cathode and anode may be in the range from 300V to 1000V. The bias voltage applied on the substrates may be in range from 0V to 1000V

In order to prevent a high power density from remaining at the same position of the target over time, which may result in melting of the target due to the sputtering process, the magnetic field and thus the position where the high plasma density takes place moves along the target's (axial) extension. This allows high power densities without harming the target. In order to make sure that a certain area of the target is not subject to high power density for a long time, the at least one magnet or magnetic field generation device is moved by at least a distance greater than the axial length of the at least one magnet or magnetic field generation device. This ensures that there is no overlap of the sputtering areas over the time so that the heat of each sputtering area does not become excessive, or each sputtering area cools down or can be cooled down in an efficient way before being subject to sputtering again.

The axial length of the target and the distance or moving range of the moving means may be at least 4 times, preferably at least 7.5 times greater than the axial length of the at least one magnet or magnetic field generation device. E.g. the axial length of the target and the distance or moving range of the moving means may be 500mm, whilst the axial length of the at least one magnet or magnetic field generation device may be only 50 to 70mm, preferably 66mm.

The moving speed may be in the range from 0.1 to 2.0 m/s, more preferably in the range from 0.3 to 1.0 m/s. The moving means may move the at least one magnet or magnetic field generation device (relative to the target) in a reciprocating manner.

Further, the magnetron sputtering apparatus may be configured to control the moving speed of the at least one magnet or magnetic field generation device such that a local temperature of the cathode, especially at turning points of the magnet/at the end of the moving range, does not exceed a predetermined temperature value. Thus, local overheating due to the high power density can be avoided.

The cathode could have any geometric form, but according to the invention the cathode is tubular as the above described effects on the magnetic field can be best achieved if the cathode is cylindrical or tubular. In case where the target is separate to the cathode the target is also tubular and arranged outside of the cathode. This configuration allows the use of a cylindrical magnet assembly inside the cathode so that a ring-like magnetic field surrounding the target can be generated for stabilizing the plasma.

The cathode may be placed in the centre of the magnetron sputtering apparatus and a plurality of substrate holding means may be arranged in a circumferential direction, preferably equiangular, around the tubular target so that a line of sight is provided between each substrate supported by a respective substrate holding means and the target.

The moving means may be configured to move the at least one magnet or magnetic field generation device within the tubular cathode in an axial direction of the tubular cathode. Thus, the at least one magnet or magnetic field generation device is moving inside/within the cathode so that the magnetic field, generated by the magnet or magnetic field generating device and being outside/surrounding the cathode, is moved accordingly.

Placing the cathode and target in the centre of the apparatus and the substrates to be coated around the cathode and the target allows a simultaneous and continuous coating of all substrates. Due to the magnetic flied, plasma is confined within a relatively narrow thin ring around the target and this thing ring moves along the target whilst the at least one magnet or magnetic field generation device is moved within the tubular cathode.

The usage of a tubular cathode and the movement of at least one magnet or magnetic field generation device within the tubular cathode in an axial direction of the tubular cathode allows an easy drive and control of the moving means. The moving means can be a pneumatic drive driving a piston connected to the at least one magnet or magnetic field generation device back and forth.

The target and the plurality of substrate holding means may be configured to rotate relatively to each other. This allows to change the line of sight between the substrates and the target surface along the entire target's surface in a circumferential direction.

Each one of the plurality of substrate holding means may be configured to rotate, preferably continuously, the substrate about an axis parallel to the centre axis of the target. This allows continuously changing the surface of the substrate, which faces the target so that all front, side and rear faces of the substrates are coated in the same fashion.

The magnetron sputtering apparatus may further comprise cooling means for circulating a cooling medium along the inner surface of the target, which allows to keep the temperature of the target in an acceptable range. Since the magnetic field is moved and thus the sputtering area, sufficient cooling efficiency can be achieved even with extremely high power densities at or near the target surface.

The electromagnetic field, that is, the electromagnetic field formed by the high voltage applied by the power supply between the cathode and anode and the magnetic field formed by the at least one magnet or magnetic field generation device, may be set such that a power density at or near the surface of the target, in particular on the outer surface/diameter of the target, is at least 1 kW/cm². Such high power density results in a locally increased sputtering rate and a higher ionization of the sputtered material. Thus, each ion bringing significant kinetic and potential energies to the film growth process thereby contributing to better physical properties of the deposited layer.

The target and the at least one magnet or magnetic field generation device may be arranged and configured such that a maximum value of an active tangential component of a magnetic flux density (also referenced as a maximum active tangential component) at or near the surface of the target, in particular on the outer surface/diameter of the target, becomes greater than 40mT, preferably greater than 60mT, most preferably around 80mT, in particular up to 120 mT. Since the tangential component causes the electrons to move in spirals and thereby increases the probability of collision of the electrons with neutral gas, the plasma ionization in the presence of the high tangential component can be significantly increased. Thus, the target and the at least one magnet are adapted accordingly so as to achieve a ionization in a value region which up to now could not be reached.

The target and the magnetic field generation device may be arranged and configured such that an axial length of the active tangential component at or near the surface of the target, in particular on the outer surface/diameter of the target, is in the range from 0.3 to 0.5 times the outer diameter of the target and/or is in the range from 0.5 to 0.8 times an axial dimension of the at least one magnet. The axial length of the active tangential component is defined as the width of the curve portion including the (absolute) maximum value of the tangential component. In other words, the axial length is defined by the limits of the curve portion including the (absolute) maximum value, that is, the difference between the two values of the independent variable at which the dependent variable is equal to 0 mT, the maximum value lying in-between these two values. In other words, it is the width of the curve portion with the (absolute) maximum value measured between those points on the y-axis which are 0 mT. For example, in case the maximum value of the active tangential component is a positive value, the axial length is the area where the tangential component is greater or equal to 0 mT. For example, in case the maximum value of the active tangential component is a negative value, the axial length is the area where the tangential component is less or equal to 0 mT.

In particular, the axial length of the active tangential component may be greater than 10mm, preferably greater than 20mm. For example, the axial length may be less than 80mm, preferably less than 60mm. For example, the axial length of the active tangential component may be in the range from 30 to 50mm, preferably 40mm. Thereby, the plasma ring around the target can be kept narrow thin, thereby concentrating the sputtering area and increasing the power density in that area. The axial movability of the at least one magnet or magnetic field generation device can compensate for the fact that said area is relatively small.

The target and the at least one magnet or magnetic field generation device may be arranged and configured such that the maximum active tangential component at or near the surface of the target, in particular on the outer surface/diameter of the target, is in the range from 1.8 to 2.2 mT/mm times the axial length, preferably about 2.0 mT/mm times the axial length. Such a gradient of the magnetic field has proven to be particularly beneficial for the efficiency of the sputter rate.

The target and the at least one magnet or magnetic field generation device may be arranged and configured such that a maximum parasitic tangential component of the magnetic flux density at or near the surface of the target, in particular on the outer surface/diameter of the target, becomes less than 30mT, preferably less than 25mT. For example, the maximum parasitic tangential component may be about 20mT. The parasitic component is defined as the (largest) extreme value of the tangential component that lies outside the axial length. For example, in case the maximum value of the active tangential component is a positive value (global maximum), a global minimum, local maxima or local minima may be the parasitic component. For example, in case the maximum value of the active tangential component is a negative value (global minimum), a global maximum, local maxima or local minima may be the parasitic component.

The target and the at least one magnet or magnetic field generation device may be arranged and configured such that a quotient of the maximum parasitic tangential component and the maximum active tangential component at or near the surface of the target, in particular on the outer surface/diameter of the target, is less than 100%, preferably 75%, more preferably less than 50%, further preferably less than 40%, further preferably less than 30%. For example, the quotient may be about 25%. Thus, the sputtering efficiency is improved.

As outlined above, I magnetic field generation device is formed by a pack of three annular magnets, preferably NdFeB magnets, being arranged in an axial direction of the target. According to an aspect of the invention these magnets may be separated by two annular magnetic steel plates, wherein said pack is being attached to a piston extending in an axial direction of the cathode and being moveable by the moving means in a reciprocating manner.. The usage of steel cores or magnetic steel plates allows to increase the tangential component of the magnetic flux density at or near the outer diameter of the target.

The axial length of the center magnet or the main magnet may be greater than the axial length of each of the two outer or side magnets. Preferably, it may be 2.0 to 2.5 times greater than the axial length of each of the two side magnets or auxiliary magnets, in particular it may be 2.3 times greater than the axial length of each of the two outer magnets or auxiliary magnets.

The axial length of the center magnet may be in the range from 25mm to 35mm, preferably 30mm.

The axial length of each of the auxiliary side magnets may be in the range from 10mm to 15mm, preferably 13mm.

The axial length of each of the two steel plates may be smaller than the axial length of each of the auxiliary side magnets. Preferably, it may be 2.0 to 3.0 times smaller than the axial length of each of the auxiliary side magnets. In particular, it may be 2.6 times smaller than the axial length of each of the auxiliary side magnets.

The axial length of each of the two steel plates may be in the range from 4.0mm to 6.0mm, preferably 5.0mm.

The inner diameter of the annular target may be 1.5. times greater than the outer diameter of the annular magnets.

The outer diameter of the annular target may be 1.8 to 2.0 times greater than the outer diameter of the annular magnets.

Preferably, the outer diameter of the annular target may be 110mm, the inner diameter of the annular target may be 90mm, the outer diameter of the annular magnets may be 60mm, and the inner diameter of the annular magnets may be 23mm.

The target may have a length, which is 5 times greater than its outer diameter. The target may have a length of 500mm.

A thus configured magnetron sputtering apparatus allows high values of the (active) tangential component of the magnetic flux density, only small parasitic magnetic fields next to the main magnetic field, and a high power density at or near the target surface.

The distance between the target and the at least one substrate may be from 2cm to 15cm. This results in an excellent coating performance.

The above-described magnetron sputtering apparatus allows to control the magnetic field strength and the power density such that with a Titanium-target a metal ionization of at least 30% is achieved.

Moreover, it was found that due to the single and slim plasma spot used in the above-described magnetron sputtering apparatus the thickness of a coating on the substrate can be easily controlled and made uniform along its axial dimension, namely just by controlling said moving means and/or said magnetic field generation device.

### Brief Description of the Drawings

Fig. 1 is a schematic illustration of a magnetron sputtering apparatus;
Fig. 2 shows a detailed view of a cathode, a magnet and a piston of the magnetron sputtering apparatus;
Figs. 3 to 5 show different views of a substrate holding means of the magnetron sputtering apparatus;
Fig. 6 shows the magnetron sputtering apparatus;
Fig. 7A to 7C show magnetic field lines in connection with different magnet arrangements;
Fig. 8 and 9 show diagrams with experimental results;
Fig. 10A and 10B show diagrams of ionisation rates which can be achieved by the described technology compared to the prior art;
Fig. 11 shows magnetic field lines of the magnet of the magnetron sputtering apparatus and corresponding characteristic parameters of a generated magnetic field;
Figs. 12 to 16 show different configurations of magnets and their corresponding characteristic parameters of a generated magnetic field; and
Fig. 17 show different curves illustrating the magnetic field measured at a different measuring diameters.

### Detailed Description of the Embodiments

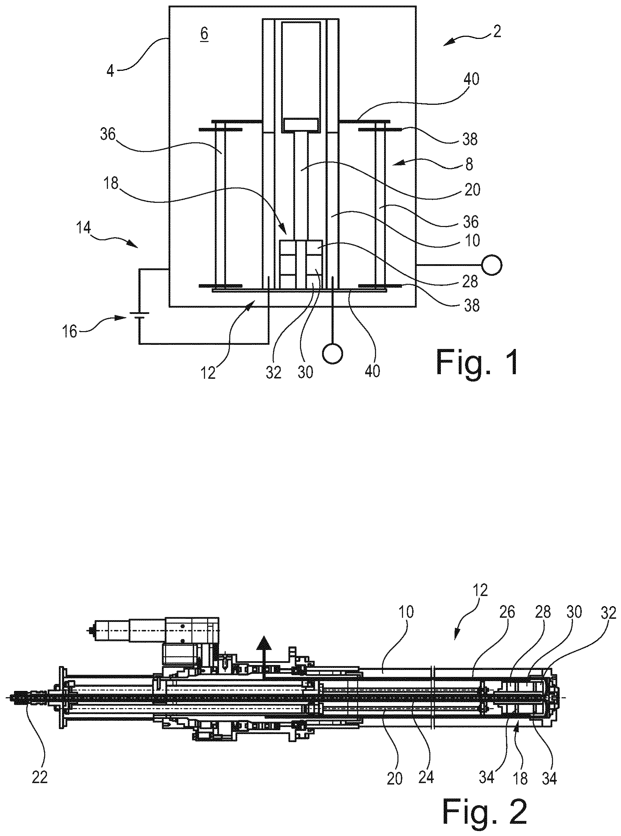

Fig. 1 shows a magnetron sputtering apparatus 2. The magnetron sputtering apparatus 2 may be used for coating a substrate, in particular with AlCr, AlTi, Ti, or ta-C based sputter targets for AlCrN, AlTiN, TiN or ta-C based thin film preparation. The substrate may be coated with a coating material, in particular a hard layer, based on metal or a metal alloy, for example with aluminium chrome nitride (AlCrN), titanium aluminium nitride (AlTiN), titanium nitride (TiN) or tetra amorphous carbon (Ta-C).

The magnetron sputtering apparatus 2 comprises a treatment/evacuation/coating chamber 4. The treatment chamber 4 can be closed/sealed in a gas-tight manner and evacuated. The (evacuated) treatment chamber 4 is configured to be supplied/filled with sputtering gases 6. As the name implies, the sputtering gas 6 is used to sputter, that is, to atomize, the coating material to be applied to the substrate, so that the sputtered/atomized coating material is deposited on the substrate and forms the coating. The sputtering gas 6 may be a noble gas, such as argon (Ar), in particular with a partial pressure from 0.1Pa to 1Pa, or xenon (Xe). Alternatively, the sputtering gas 6 may be a gas of the nitrogen group, such as nitrogen (N₂), in particular with a partial pressure from 0.05Pa to 0.3Pa.

Further, the magnetron sputtering apparatus 2 comprises substrate holding means. The substrate holding means are arranged inside the treatment chamber 4. The substrate holding means, in the embodiment shown, are in the form of a carousel holder 8. The carousel holder 8 may receive/hold the substrate (or several substrates) to be coated at a predetermined position within the treatment chamber 4.

The magnetron sputtering apparatus 2 comprises a target 10. The target 10 forms the coating material for coating the substrate and can e.g. be made of AlCr, AlTi, Ti, C, TiB2 to make AlCrN, AlTiN, TiN, ta-C based coatings. Those targets may additionally be doted up to 10at% with Si, W, B, Ta, V, etc.. During magnetron sputtering, microscopic particles are released from the target 10 and deposited on the substrate. The target 10 is facing the substrate and is subject to sputtering of the sputtering gas 6 within the treatment chamber 4. In particular, the target 10 is subject to sputtering by plasma, that is, matter with a sufficiently high proportion of free ions and electrons, i.e. with a high ionization, wherein the plasma is formed/generated in the treatment chamber 4. For example, the (radial) distance between the target 10 and the substrate may be in the range from 2cm to 15cm.

The magnetron sputtering apparatus 2 further comprises a cathode 12, an anode 14 and a power supply 16 for applying high voltage between the cathode 12 and the anode 14. The voltage applied between the cathode 12 and the anode 14 may be in the range from 300V to 1000V.

In particular, the cathode 12 is formed by the target 10 or supports the target 10, whereas the anode 14 is formed by the treatment chamber 4. In other words, the power supply 16 is configured to apply high voltage between the treatment chamber 4 and the target 10 with the substrate positioned in-between the cathode 12 and the anode 14. That is, an electrical field between the target 10 and the treatment chamber 4 may be built up by means of the voltage supply 16, the substrate being positioned in the electric field. A bias voltage applied on the substrate may be in range from 0V to 1000V.

Further, the magnetron sputtering apparatus 2 comprises a magnetic field generation device 18 forming a magnetic field so as to confine electrons in the plasma at or near a surface of the target 10. In other words, the magnetron sputtering apparatus 2 comprises the magnetic field generation device 18 configured to build up the magnetic field, the magnetic field being superimposed on the electric field. Thus, due to superposition of the electric and magnetic fields, the electrons no longer move parallel to the electric field lines, but are deflected such that their path is lengthened and the number of collisions per electron increases. Hence, the electron density is highest at the point where the magnetic field is parallel to the surface of the target 10, which causes a higher ionization in this area. The magnetic field generation device 18 is always situated below the plasma, i.e. its position defines where the plasma burns. Thus, plasma is generated especially in the area where the magnetic field is parallel to the surface of the target 10 and the sputtering of the target is performed in said area.

In particular, the electrical field formed by the high voltage applied by the power supply 16 between the cathode 12 and the anode 14 and the magnetic field formed by the magnetic field generation device 18 are set such that a power density - defined as a product of magnetic field strength and electrical field strength - at or near the surface of the target 10, particular on an outer surface of the target 10, is at least 500 W/cm² up to 1 kW/cm². The outer surface of the target 10 being on a side facing the substrate and the anode 14 and facing away from the magnetic field generation device 18.

The magnetic field generation device 18 is arranged behind the cathode 12/the target 10, that is, on an inner side of the target 10, i.e. not on the same side of the target 10 as the substrate. In the shown embodiment, the target 10 and the substrate/the substrate holding means are arranged radially stacked. That is, the substrate is arranged radially outside the target 10 and the magnetic field generation device 18 is arranged radially inside the target 10.

According to the invention, the magnetron sputtering apparatus 2 comprises moving means for moving the at least one magnet or magnetic field generation device 18 in an axial direction of the target 10 and/or of the cathode 12. The moving means, in the embodiment shown, are in the form of an axially movable piston 20, e.g. pneumatically driven, coupled to the magnetic field generation device 18. In other words, the magnetron sputtering apparatus 2 comprises the axially movable magnetic field generation device 18, that is, the magnetron sputtering apparatus 2 is configured to generate a magnetic field which is movable, in particular along the axial direction/longitudinal direction of the cathode 12/the target 10. The magnetic field generation device 18 is attached to the piston 20 extending in the axial direction of the cathode 12 and is moveable by the piston 20 in a reciprocating manner.

Preferably, the piston 20 may be configured to move the magnetic field generation device 18 by at least a distance greater than the axial length of the magnetic field generation device 18. That is, the moving range of the magnetic field generation device 18 is greater than the axial dimension of the magnetic field generation device 18. In particular, the moving range of the magnetic field generation device 18 may substantially correspond to or be at least as large as the maximal axial dimension of the substrate to be coated and/or the axial length of the target 10.

Preferably, the piston 20 may be configured to move the magnetic field generation device 18 with a speed in the range from 0.1 to 2.0 m/s, more preferably in the range from 0.3 to 1.0 m/s. Thus, with an axial length of the target in the rage of about 500 mm, the magnetic field generation device 18 performs an oscillating movement with a frequency in the range of about 1 Hz.

Fig. 2 shows the cathode 12, the magnetic field generation device 18 and the piston 20 in detail.

The cathode 12 is formed by a tubular cathode enclosing a cylindrical hollow volume. The magnetic field generation device 18 and the piston 20 are arranged within the cathode 12/target 10.

The target 10 is annular/tubular. The target 10 may have an outer diameter in the range from 80mm to 120mm, for example, 110mm or 105mm. Further, the target 10 may have an inner diameter of 60mm to 100mm, for example, 90mm.

Further, the magnetron sputtering apparatus 2 may comprise cooling means for circulating a cooling medium 22 along the inner surface of the target 10. The cooling means, in the embodiment shown, are in the form of a central feed tube 24 extending radially inside the piston 20, the target 10 and the magnetic field generation device 18 from a first axial end to a second axial end of the cathode 12, and an annular channel 26 connected to the feed tube 24 and extending directly radially inside on the inner surface of the target 10 from the second axial end towards the first axial end of the cathode 12.

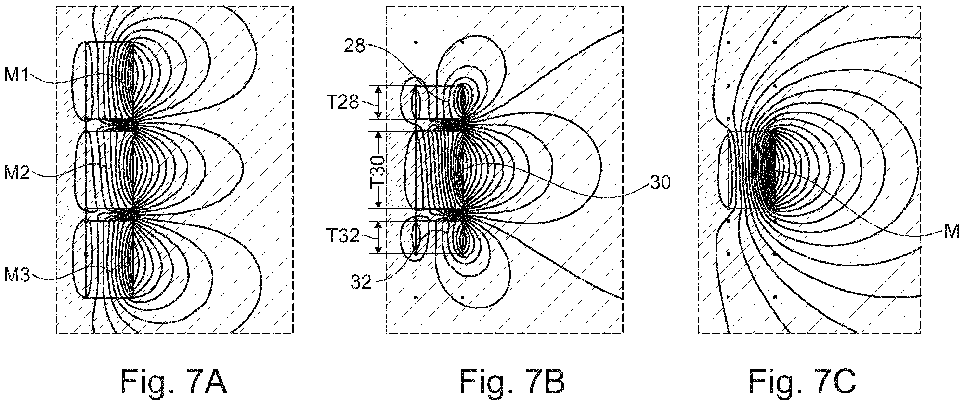

In order to reach and properly stabilize power densities in the above-mentioned range the formation of plasma has to be exactly controlled by a specifically dimensioned magnetic field generation device. As illustrated in figure 7A to 7C, in which magnetic field lines are shown in connection with different magnet arrangements, it was found by experiments that - in combination with the above-described controlled movement of the magnetic field generation device 18 - only the magnet arrangement shown figure 7B can be used to solve this problem.

Figure 7A shows the magnetic field lines of a magnetic field generation device with several magnetically equal strong magnets M1 to M3. This magnetic field generation device leads to a situation in which the magnetic fields are equally strong and equally oriented so that the target will be eroded at three spots, which substantially decreases power density.

The magnet arrangement shown in figure 7C uses only a single magnet M. With this configuration this single magnet can be selected to have a very high magnetic field. However, such magnetic field is wide as well so that the plasma spot cannot be easily controlled.

This magnetic field generation device 18 shown in figure 7C has a set of three aligned magnets 28, 30 and 32, wherein a center magnet 30 is oppositely poled to and magnetically stronger than the side magnets 28 and 32, thereby concentrating the magnetic field - to be seen when comparing figure 7C and figure 7B - to a slimmer area at the center magnet 30. This allows the generation of peak power densities above 500 W/cm² at or near the target surface. In spite of this increased power density, however, the target is protected from melting since the magnetic field generation device 18 is continuously moved whereby the area where the target evaporates is somewhat stretched.

This concept of sandwiching a main magnet between two auxiliary magnets allows to influence the field lines of the main center magnet. In detail, the field lines of the main magnet are condensed in an axial direction since the strong magnetic fields are oriented against each other to slim the magnetic field. By such arrangement magnetic field is axially concentrated to a single a slim area at the center magnet for allowing there at or near the target surface the generation of sufficiently high peak power densities, also as the magnetic field has an influence on the electric field. Consequently the transition to the peak of the magnet field is sharp so that the plasma is ignited at a single spot.

Figure 7B shows one option of designing the magnetic field generation device 18 such that the above-described magnetic field can be established. Here, all magnets of the magnetic field generation device are made of the same magnetic material, and the center magnet 30 has a thickness T30 which is greater than thickness T28, T32 of the side magnets 28, 32.

Alternatively, the materials for the magnets are selected such that the center magnet is made of a magnetically stronger material than the side magnets.

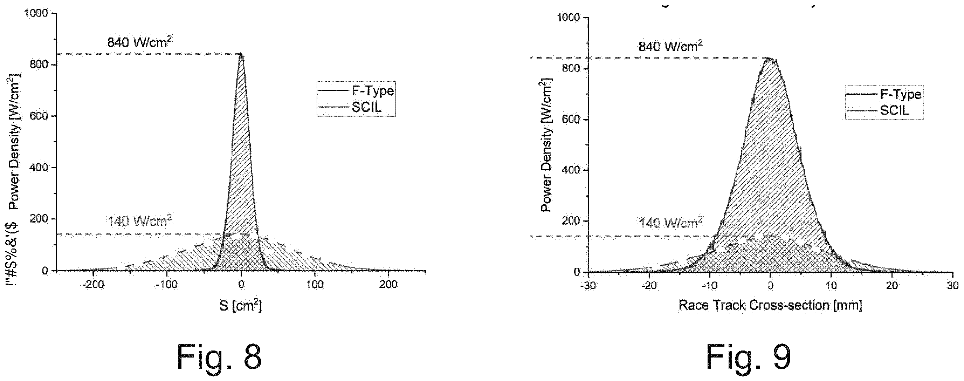

Experimental results are illustrated in figures 8 and 9. Figure 8 shows with black curve the power density over the surface of the target. Figure 9 shows the power density over the cross section of the race track, i.e. the track which is generated when the moving ionized plasma leads to the expulsion of target atoms to the substrate. The dotted lines show the power density, which can be achieved with the same power when performing a sputtering using Lateral Glow Discharge Technology. The power densities were measured/calculated when operating the magnetron sputtering apparatus 2 at a power of 25 kW.

As can be taken from figures 8 and 9, whilst three magnets are active, the power density follows a single peak curve so that the plasma is stabilised at a single spot which is much narrower than the curve (dotted line) of a conventional sputtering technology. The curve has a relatively great gradient which means that the maximum values of the power density are located at a slim area AS. Consequently, the metal deposition can be more accurately controlled since the plasma is present only at a single spot defining the sputtering space where the sputtering burns. Moreover, since the maximum of the power density is restricted to a slim area and in view of the above-described movement of the magnetic field generation device 18, the temperature of the target can be more easily kept within a controllable range even with power densities above 1 kW/cm² which so far could not be realized without melting the target. Also, besides an efficient use of energy, such configuration leads to a narrower wear profile, i.e., a slimmer race track on the target, thus facilitating a uniform and balanced controlled consumption of the target.

Further experiments revealed that with the above-described configuration a much higher plasma ionization and thus a much higher metal ionisation rate could be reached. In cooperation with Masaryk University, Brno, Czech Republic, the metal ionization for a Ti target was evaluated. Here, a negatively biased flat Langmuir probe is introduced to the discharge plasma, repelling the electrons and collecting all positively charged ions. Obtained ion flux equals to overall positive particle current. The system was combined with a bias able quartz crystal microbalance (QCM) measuring mass of film forming species deposited on it. If positively biased it repels the positive film forming ions. These two complementary measurements provide distinction between ionic and atomic mass of thin film forming species.

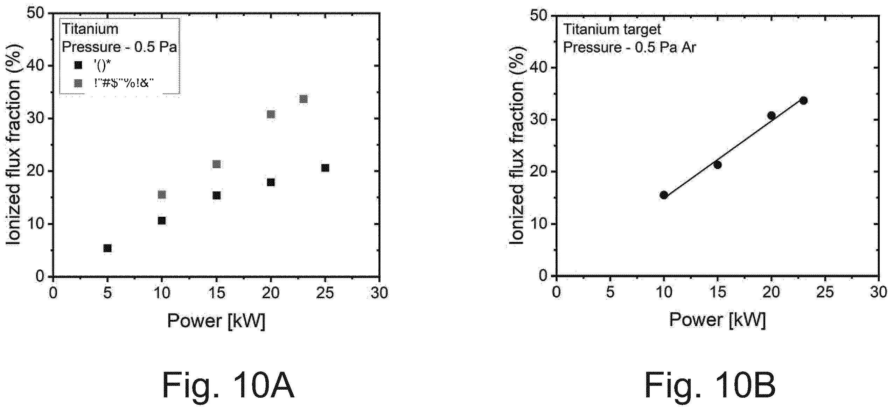

Figures 10A and 10B show that when operating the magnetron sputtering apparatus 2 with a power of about 25 kW an ionized flux fraction of 35% could be reached, a substantially higher value than what can be reached with sputtering using Lateral Glow Discharge Technology. Thus, in the deposition process a higher energy density, i.e. energy per deposited atom, can be reached, which can be used for improving the properties of the deposited layer or coating, in particular density, crystal structure and/or grain size.

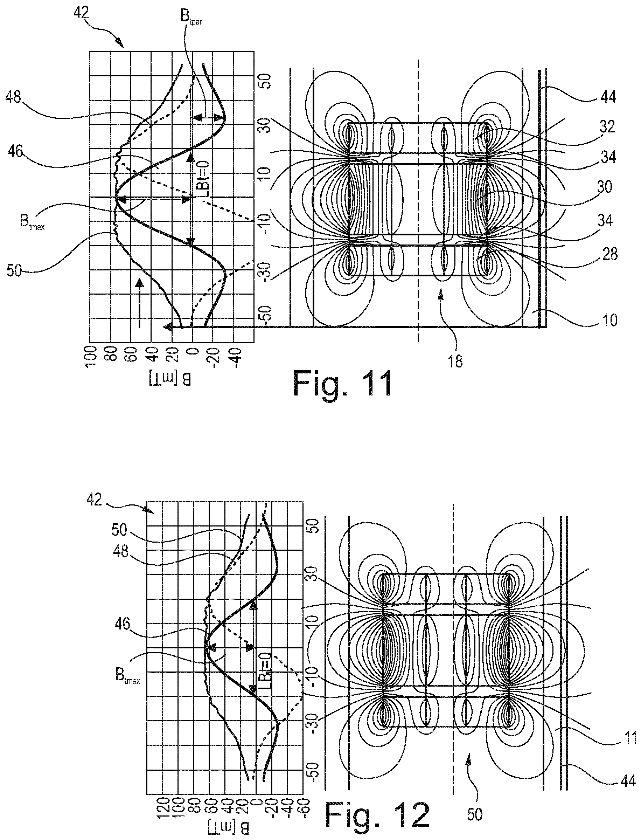

As shown in figure 11, the magnetic field generation device 18 is constituted by such pack of three single annular magnets 28, 30, 32. The single annular magnets 28, 30, 32 may preferably be neodymium iron boron magnets (NdFeB magnets). The annular magnets 28, 30, 32 are arranged axially stacked, i.e. arranged adjacent in the axial direction of the target 10. The polarity of adjacent magnets is oppositely oriented. The three single annular magnets 28, 30, 32 are separated by two annular magnetic steel plates 34, i.e. a first steel plate 34 is arranged axially between the first single annular magnet, i.e. the first side magnet 28 and the center magnet 30, and a second steel plate 34 is arranged axially between the center magnet 30 and the second side magnet 32.

In particular, the axial length of the center magnet 30 (i.e. the middle magnet) may be 2.0 to 2.5 times, in particular 2.3 times, greater than the axial length of the side magnets 28 and 32 (i.e. each of the two outer magnets). For example, the axial length of the center magnet 30 (i.e. the middle magnet) may be in the range from 25mm to 35mm, preferably 30mm, and the axial length of the side magnets 28 and 32 (i.e. each of the two outer magnets) may be in the range from 10mm to 15mm, preferably 13mm.

In particular, the axial length of each of the two steel plates 34 may be 2.0 to 3.0 times, in particular 2.6 times, smaller than the axial length of the side magnets 28 and 32 (i.e. each of the two outer magnets). For example, the axial length of each of the two steel plates 34 may be in the range from 4.0mm to 6.0mm, preferably 5.0mm.

Further, the inner diameter of the annular target 10 may be 1.5. times greater than the outer diameter of the magnetic field generation device 18. Further, the outer diameter of the annular target may be 1.8 to 2.0 times greater than the outer diameter of the magnetic field generation device 18. For example, the outer diameter of the magnetic field generation device 18 (each of the three single magnets 28, 30, 32) may be 60mm, and the inner diameter of the magnetic field generation device 18 (each of the three single magnets 28, 30, 32) may be 23mm.

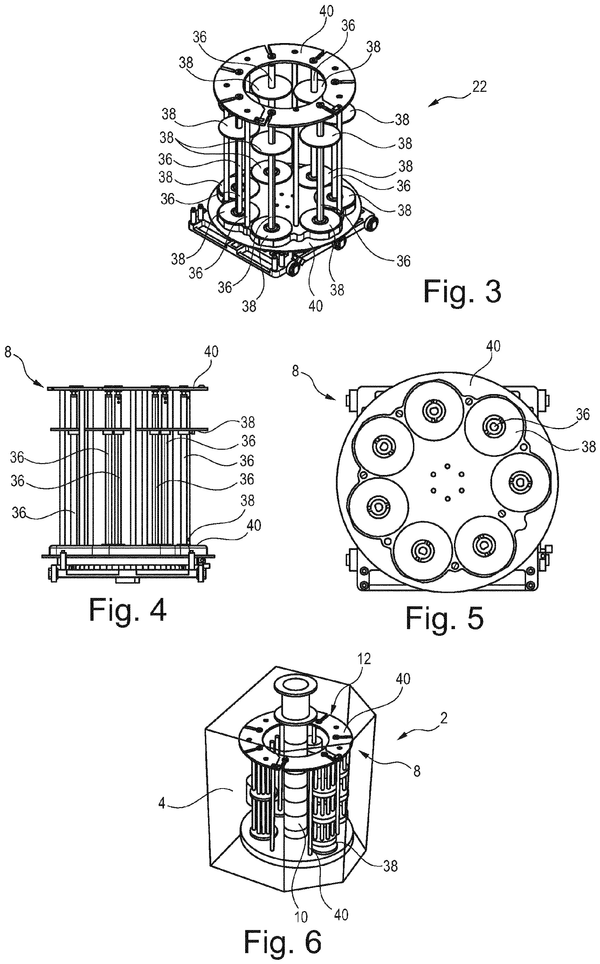

Figs. 3 to 5 show the substrate holding means in the form of the carousel holder 8. The carousel holder 8 comprises a plurality of rods/bars 36, in the embodiment shown seven rods 36, extending in the axial direction. Each of the rods 36 is configured to hold one or a plurality of substrates to be coated. The substrates may be held directly by the rods 36 or preferably by means of a basket or tray into which the substrates can be inserted. The rods 36 are arranged in a circumferential direction such that each of the rods 36 is the same distance from the centre of the carousel holder 8 (i.e. the same distance from the cathode 12/target 10 when mounted). Two axially spaced discs 38 are attached to each of the rods 36, between which the substrate to be coated can be placed. The rods 36 are sandwiched between and attached to two axially spaced plates 40.

Preferably, each of the rods 36 or each of the discs 38 is configured to rotate about its longitudinal axis. Thus, the substrates held by the substrate holding means may be rotated about an axis parallel to the center axis of the target 10, i.e. parallel to the axial direction. In other words, the target 10 and the plurality of substrate holding means are configured to rotate relatively to each other. In particular, the substrate rotates around the target 10, while the target 10 is not rotating.

Fig. 6 shows the magnetron sputtering apparatus 2 with the carousel holder 8 being positioned within the treatment chamber 4 and the cathode 12 positioned in a radial centre of the carousel holder 8. The movable magnetic field generation device 18 is arranged within the cathode 12 and axially movable in the range between the plates 40 or between the discs 38 of the carousel holder 8.

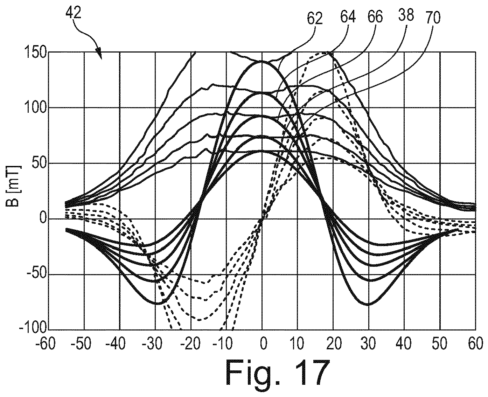

Referring now to figures 11 to 17 some embodiments and comparative examples of magnet arrangements and their magnetic fields are described.

Fig. 11 shows the magnetic field lines of the magnetic field generation device 18 and a graph 42 illustrating the magnetic field measured at a measuring diameter 44, the measuring diameter 44 being near the surface of the target 10 or preferably within the target 10, in particular at a diameter of 105 mm. In the graph 42, a tangential component of a magnetic flux density is illustrated by a curve 46, a normal component of the magnetic flux density is illustrated by a curve 48 and an absolute value of the magnetic flux is illustrated by a curve 50.

As can be seen in the graph 42, the tangential component of the magnetic flux density is largest in the centre (in the axial direction) of the magnetic field generation device 18. The tangential component decreases as the distance from the centre of the magnetic field generation device 18 increases. That is, the curve 46 substantially follows a cosine function.

A first characteristic parameter describing the curve 46 describing the tangential component of the magnetic flux density, in particular the gradient of the curve 46, is a maximum active tangential component Btₘₐₓ, which corresponds to a (absolute) maximum value of an active tangential component of the magnetic flux density. The maximum active tangential component Btₘₐₓ may correspond to an intersection point between the curve 46 and the Y-axis of the graph 42. In the magnetic field generation device 18 with the configuration as described above, the maximum active tangential component of the magnetic flux density Btₘₐₓ is about 75 mT, i.e. greater than 40mT and greater than 60mT, respectively.

A second characteristic parameter describing the curve 46 describing the tangential component of the magnetic flux density, in particular the gradient of the curve 46, is an axial length/width of the active tangential component L_{Bt=0}. In the shown embodiment, the maximum active tangential component Btₘₐₓ is a positive value and thus, the axial length is the length of an area where the active tangential component is equal to or greater than 0mT. (If the maximum active tangential component Btₘₐₓ would be a negative value, the axial length would be the length of an area where the active tangential component is equal to or less than 0mT.)

The axial length of the active tangential component L_{Bt=0} corresponds to a distance between intersection points between the curve 46 and the X-axis of the graph 42. In the magnetic field generation device 18 with the configuration as described above, approximately at a distance of 20mm from the centre of magnetic field generation device 18, the tangential component is 0mT. That is, the length of the active tangential component L_{Bt=0} is about 40mm, that is, in the range from 30mm to 50mm, i.e. less than 80mm and less than 60mm, respectively, and greater than 10mm and greater than 20mm, respectively.

In relation to the outer diameter of the target 10, the length of the active tangential component L_{Bt=0} is in the range from 0.3 to 0.5 times the outer diameter of the target 10.

A third characteristic parameter of the curve 46 describing the tangential component of the magnetic flux density is a parasitic tangential component Btₚₐᵣ, which corresponds to a maximum value of a negative tangential component of the magnetic flux density, that is, a global minimum. Alternatively, the parasitic tangential component Btₚₐᵣ may correspond to a local maximum. (If the maximum active tangential component Btₘₐₓ would be a negative value, the parasitic tangential component Btₚₐᵣ would be a global maximum or local minimum.)

In other words, the parasitic tangential component Btₚₐᵣ is an extreme value of the curve 46 outside of the axial length of the active tangential component L_{Bt=0}. In the magnetic field generation device 18 with the configuration as described above, the parasitic tangential component Btₚₐᵣ is about 20mT, i.e. less than 30mT and less than 25mT, respectively.

A fourth characteristic parameter of the curve 46 describing the tangential component of the magnetic flux density is a quotient Btₚₐᵣ/Btₘₐₓ of the maximum parasitic tangential component Btₚₐᵣ and the maximum active tangential component Btₘₐₓ. In the magnetic field generation device 18 with the configuration as described above, the quotient Btₚₐᵣ/Btₘₐₓ is about 25%, i.e. less than 100%, 75%, 50%, 40% and 30%, respectively.

As can be seen in the graph 42, the normal component of the magnetic flux density is zero in the centre (in the axial direction) of the magnetic field generation device 18. The normal component decreases as the distance from the axial centre of the magnetic field generation device 18 in one direction increases and the normal component increases as the distance from the axial centre of the magnetic field generation device 18 in the other direction increases. That is, the curve 48 substantially follows a sinusoidal function.

In the following, with reference to Figs. 12 to 16, it is described how a change in the configuration of the magnetic field generation device 18 affects the characteristic parameters.

Fig. 12 shows a magnetic field generation device 50 having an air core instead of a steel core/the steel plates 34 of the magnetic field generation device 18. As a significant difference, the magnetic field generation device 50 has a reduced maximum tangential component Btₘₐₓ compared to the magnetic field generation device 18, the maximum tangential component Btₘₐₓ being about 60mT. Further, the magnetic field generation device 50 is hard to construct.

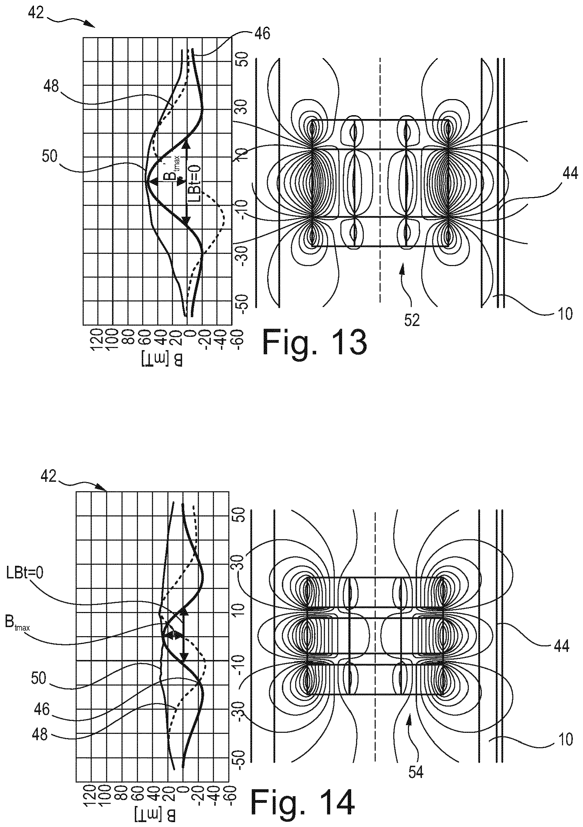

Fig. 13 shows a magnetic field generation device 52 having no core instead of the steel core/the steel plates 34 of the magnetic field generation device 18. That is, the three single annular magnets of the magnetic field generation device 52 are directly adjacent to each other/contact each other. As a remarkable difference, the magnetic field generation device 52 has a significantly reduced maximum active tangential component Btₘₐₓ compared to the magnetic field generation device 18, the maximum active tangential component Btₘₐₓ being about 50mT. Further, the magnet field generation device 52 is very hard to construct.

Fig. 14 shows a magnetic field generation device 54 having a smaller center magnet compared to the magnetic field generation device 18, the middle magnet being 15mm, that is, about as big as each of the outer magnets. As a significant difference, the magnetic field generation device 54 has a significantly reduced maximum active tangential component Btₘₐₓ compared to the magnetic field generation device 18, the maximum active tangential component Btₘₐₓ being about 30mT. Further, the magnet 54 has a significantly increased quotient Btₚₐᵣ/Btₘₐₓ compared to the magnetic field generation device 18, the quotient Btₚₐᵣ/Btₘₐₓ being about 100%. Further, the magnetic field generation device 54 has a reduced length of the active tangential component L_{Bt=0} compared to the magnetic field generation device 18, the length of the active tangential component L_{Bt=0} being about 20mm.

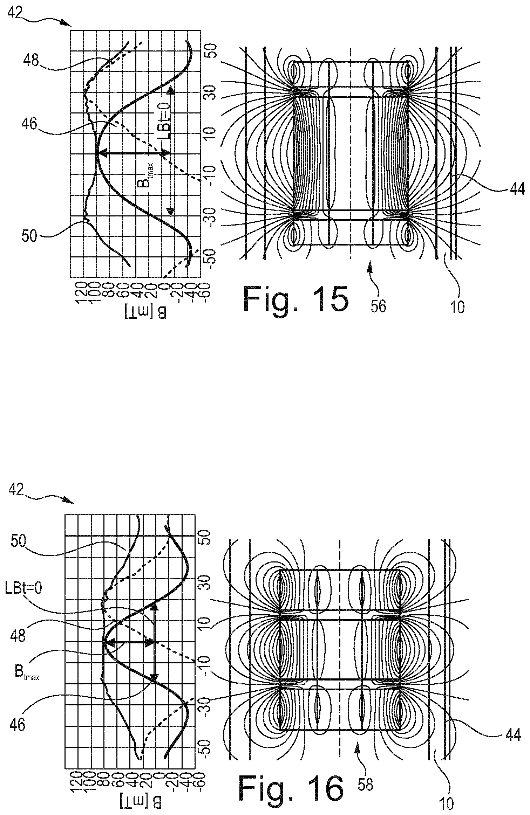

Fig. 15 shows a magnetic field generation device 56 having a bigger center magnet compared to the magnetic field generation device 18, the center magnet being 60mm, that is, about four times as big as each of the side magnets. The magnetic field generation device 56 has an increased maximum active tangential component Btₘₐₓ compared to the magnetic field generation device 18, the maximum active tangential component Btₘₐₓ being about 100mT. As a significant difference, the magnetic field generation device 56 has a significantly increased length of the active tangential component L_{Bt=0} compared to the magnetic field generation device 18, the length of the active tangential component L_{Bt=0} being about 70mm.

Fig. 16 shows a magnetic field generation device 58 having slightly bigger side magnets and a slightly bigger center magnet compared to the magnetic field generation device 18, each of the outer magnets being 20mm and the middle magnet being 30mm, that is, the center magnet being about 1.5 times as big as each of the side magnets. The magnetic field generation device 58 has a similar maximum active tangential component Btₘₐₓ as the magnetic field generation device 18, the maximum active tangential component Btₘₐₓ being about 80mT. As a significant difference, the magnetic field generation device 58 has a significantly increased quotient Btₚₐᵣ/Btₘₐₓ compared to the magnetic field generation device 18, the quotient Btₚₐᵣ/Btₘₐₓ being about 50%.

Fig. 14 shows several curves illustrating the magnetic field simulated/measured at different measuring diameters of the target 10. A first curve 62 is at a diameter of 90mm, a second curve 64 is at a diameter of 95mm, a third curve 66 is at a diameter of 100mm, a fourth curve 68 is at a diameter of 105mm, and a fifth curve 70 is at a diameter of 110mm. The length of the active tangential component L_{Bt=0} is substantially the same, regardless of the diameter. The maximum active tangential component Btₘₐₓ differs from about 140mT (first curve 60) to about 60mT (fifth curve 68). Thus, the gradient of the curves become smaller the closer to the magnetic field generation device 18/inner surface of the target 10 the diameter is positioned.

The above magnetron sputtering apparatus 2 not only allows to control the magnetic field strength and the power density such that metal ionization of at least 30% is achieved. Moreover, this magnetron sputtering apparatus 2 allows to control said moving means and/or said magnetic field generation device such that a thickness of a coating on the substrate is uniform along its axial dimension.

With the above-described magnetron sputtering apparatus 2 it is thus possible to achieve plasma ionisation in a range which substantially improves the physical properties of the sputtered layer. For example, as the following diagram shows, 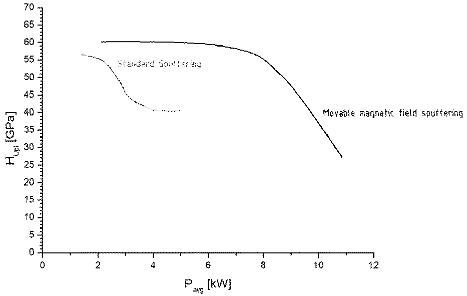 a coating of a tetrahedrally bound hydrogen-free amorphous carbon (ta-C) layer produced with the above-described technology reaches a substantially higher hardness, i.e. plastic hardness (H) compared to a layer that is produced by standard sputtering. This means that the diamond part in the layer can be made much higher. Moreover, the above diagram reveals that the specific hardness can be kept at a higher level over a wide range of average power P.

## Claims

1. A magnetron sputtering apparatus (2) for coating a substrate, preferably with AlCr, AlTi, Ti, or ta-C based sputter targets for AlCrN, AlTiN, TiN or ta-C based thin film preparation, comprising:
a treatment chamber (4) to be evacuated and then to be supplied with a sputtering gas (6), such as Ar, preferably with an Ar partial pressure from 0.1Pa to 1Pa, Xe and/or N₂, preferably with a N₂ partial pressure from 0.05Pa to 0.3Pa;
substrate holding means (8) for holding the substrate;
a tubular cathode (12), an anode (14) and a power supply (16) for applying high voltage, preferably from 300V to 1000V, between the cathode and the anode;
a tubular target (10) forming the cathode (12) or being supported by the cathode (12), facing the substrate and being subject to sputtering by plasma formed within the treatment chamber (4),
a magnetic field generation device forming a magnetic field so as to confine electrons in the plasma at or near a surface of the target (10); and
moving means (20) for moving the magnetic field generation device in an axial direction of the target (10), preferably by at least a distance greater than the axial length of the magnetic field generation device (18), preferably with a speed in the range from 0.1 to 2.0 m/s, more preferably in the range from 0.3 to 1.0 m/s, **characterized in that**
said magnetic field generation device (18) has a set of three aligned magnets (28, 30, 32), wherein a center magnet (30) is oppositely poled to and magnetically stronger than the side magnets (28, 32), thereby concentrating the magnetic field to a slim area at the center magnet (30) for allowing there at or near the target surface the generation of peak power densities above 500 W/cm².

2. The magnetron sputtering apparatus of claim 1, in which all magnets (28, 30, 32) of the magnetic field generation device (18) are made of the same magnetic material, and the center magnet (30) is thicker than the side magnets (28, 32).

3. The magnetron sputtering apparatus of claim 1, in which the center magnet (30) is made of a magnetically stronger material than the side magnets (28, 32).

4. The magnetron sputtering apparatus (2) according to one of the claims 1 to 3, wherein
said target (10) preferably having an outer diameter in the range from 80 to 120mm, preferably 105 mm;
a plurality of substrate holding means (8, 36) is arranged in a circumferential direction around the tubular target (10); and
the moving means (20) is configured to move the magnetic field generation device within the tubular cathode (12) in an axial direction of the tubular cathode (12).

5. The magnetron sputtering apparatus (2) according to claim 4, wherein
the target (10) and the plurality of substrate holding means (8, 36) are configured to rotate relatively to each other and/or each of the plurality of substrate holding means is configured to rotate the substrate about an axis parallel to the centre axis of the target (10).

6. The magnetron sputtering apparatus (2) according to any one of claims 1 to 5, further comprising:
cooling means (24, 26) for circulating a cooling medium (22) along an inner surface of the target (10).

7. The magnetron sputtering apparatus (2) according to any one of claims 1 to 6, wherein the electrical field formed by the high voltage applied by the power supply (16) between the cathode (12) and the anode (14) and the magnetic field formed by magnetic field generation device (18) are set such that a power density at or near the surface of the target (10), in particular on an outer surface of the target (10), is at least 1 kW/cm².

8. The magnetron sputtering apparatus (2) according to any one of claims 1 to 7, wherein
the target (10) and the magnetic field generation device (18) are arranged and configured such that a maximum value of an active tangential component of a magnetic flux density at or near the outer diameter of the target (10) becomes greater than 40mT, preferably greater than 60mT, most preferably around 80mT, in particular up to 120 mT.

9. The magnetron sputtering apparatus (2) according to claim 8, wherein
the target (10) and the magnetic field generation device (18) are arranged and configured such that an axial length the active tangential component is in the range from 0.3 to 0.5 times an outer diameter of the target (10), in particular in the range from 30 to 50mm, preferably 40mm.

10. The magnetron sputtering apparatus (2) according to any one of claims 1 to 9, the magnetic field generation device (18) comprising:
a pack of three annular magnets (28, 30, 32), preferably NdFeB magnets, being arranged in an axial direction of the target (10) and being separated by two annular magnetic steel plates (34), said pack being attached to a piston (20) extending in an axial direction of the cathode (12) and being moveable by the piston (20) in a reciprocating manner.

11. The magnetron sputtering apparatus (2) according to claim 10, wherein
the axial length of the center magnet (30) is, preferably 2.0 to 2.5 times, in particular 2.3 times, greater than the axial length of each of the two side magnets (28, 32); or
the axial length of the center magnet (30) is in the range from 25mm to 35mm, preferably 30mm, and the axial length of each of the two side magnets (28, 32) is in the range from 10mm to 15mm, preferably 13mm; and/or
the axial length of each of the two steel plates (34) is, preferably 2.0 to 3.0 times, in particular 2.6 times, smaller than the axial length of each of the two side magnets (28, 32); or
the axial length of each of the two steel plates (34) is in the range from 4.0mm to 6.0mm, preferably 5.0mm; and/or
the inner diameter of the annular target (10) is 1.5. times greater than the outer diameter of the annular magnets (28, 30, 32); or
the outer diameter of the annular target (10) is 1.8 to 2.0 times greater than the outer diameter of the annular magnets (28, 30, 32); or
the outer diameter of the annular target (10) is 110mm, the inner diameter of the annular target (10) is 90mm, the outer diameter of the annular magnets (28, 30, 32) is 60mm, and the inner diameter of the annular magnets (28, 30, 32) is 23mm.

12. The magnetron sputtering apparatus (2) according to any one of claims 1 to 11, wherein the distance between the target (10) and the at least one substrate is from 2cm to 15cm.

13. Method of operating the magnetron sputtering apparatus according to any one of claims 1 to 12, in which the magnetic field strength and the power density are controlled such that with a Titanium-target a metal ionization of at least 30% is achieved.

14. The method of claim 13, in which said moving means (20) and/or said magnetic field generation device (18) are controlled such that a thickness of a coating on the substrate is uniform along its axial dimension.

## Patentansprüche

1. Magnetron-Sputtervorrichtung (2) zum Beschichten eines Substrats, vorzugsweise mit Sputtertargets auf Basis von AlCr, AlTi, Ti oder ta-C zur Vorbereitung einer Dünnschicht auf Basis von AlCr, AlTi, Ti oder ta-C, mit:
einer Behandlungskammer (4), die zu evakuieren ist und dann mit einem Sputtergas (6), wie Ar, vorzugsweise mit einem Ar-Partialdruck von 0,1 Pa bis 1 Pa, Xe und/oder N₂, vorzugsweise mit einem N₂-Partialdruck von 0,05 Pa bis 0,3 Pa, zu füllen ist;
Substrathaltemitteln (8) zum Halten des Substrats;
einer rohrförmigen Kathode (12), einer Anode (14) und einer Stromversorgung (16) zum Anlegen einer Hochspannung, vorzugsweise von 300 V bis 1000 V, zwischen der Kathode und der Anode;
einem rohrförmigen Target (10), das die Kathode (12) bildet oder durch die Kathode (12) gelagert ist, das dem Substrat zugewandt ist und durch ein in der Behandlungskammer (4) gebildetes Plasma zerstäubt wird;
einer Magnetfelderzeugungsvorrichtung, die ein Magnetfeld erzeugt, um Elektronen in dem Plasma an oder nahe einer Oberfläche des Targets (10) zu halten; und
Bewegungsmitteln (20) zum Bewegen der Magnetfelderzeugungsvorrichtung in einer Axialrichtung des Targets (10), vorzugsweise um zumindest eine Distanz, die größer als die Axiallänge der Magnetfelderzeugungsvorrichtung (18) ist, vorzugsweise mit einer Geschwindigkeit im Bereich von 0,1 bis 2,0 m/s, weiter bevorzugt im Bereich von 0,3 bis 1,0 m/s, **dadurch gekennzeichnet, dass**
die Magnetfelderzeugungsvorrichtung (18) einen Satz von drei ausgerichteten Magneten (28, 30, 32) aufweist, wobei ein mittlerer Magnet (30) entgegengesetzt zu den seitlichen Magneten (28, 32) gepolt und magnetisch stärker als die seitlichen Magnete (18, 32) ist, wodurch das Magnetfeld auf einen schmalen Bereich am mittleren Magneten (30) konzentriert wird, um dort an oder nahe der Targetoberfläche die Erzeugung von Spitzenleistungsdichten über 500 W/cm² zu ermöglichen.

2. Magnetron-Sputtervorrichtung nach Anspruch 1, bei der alle Magnete (28, 30, 32) der Magnetfelderzeugungsvorrichtung (18) aus demselben magnetischen Material hergestellt sind und der mittlere Magnet (30) dicker ist als die seitlichen Magnete (28, 32).

3. Magnetron-Sputtervorrichtung nach Anspruch 1, bei dem der mittlere Magnet (30) aus einem magnetisch stärkeren Material als die seitlichen Magnete (28, 32) hergestellt ist.

4. Magnetron-Sputtervorrichtung (2) nach einem der Ansprüche 1 bis 3, wobei
das Target (10) vorzugsweise einen Außendurchmesser im Bereich von 80 bis 120 mm, vorzugsweise 105 mm, aufweist;
eine Vielzahl von Substrathaltemitteln (8, 36) in Umfangsrichtung um das rohrförmige Target (10) herum angeordnet ist; und
die Bewegungsmittel (20) ausgebildet sind, um die Magnetfelderzeugungsvorrichtung innerhalb der rohrförmigen Kathode (12) in einer Axialrichtung der rohrförmigen Kathode (12) zu bewegen.

5. Magnetron-Sputtervorrichtung (2) nach Anspruch 4, wobei
das Target (10) und die mehreren Substrathaltemittel (8, 36) ausgebildet sind, um sich relativ zueinander zu drehen, und/oder jedes der mehreren Substrathaltemittel ausgebildet ist, um das Substrat um eine Achse parallel zur Mittelachse des Targets (10) zu drehen.

6. Magnetron-Sputtervorrichtung (2) nach einem der Ansprüche 1 bis 5, ferner mit
Kühlmitteln (24, 26) zum Zirkulieren eines Kühlmediums (22) entlang einer Innenoberfläche des Targets (10).

7. Magnetron-Sputtervorrichtung (2) nach einem der Ansprüche 1 bis 6, wobei das elektrische Feld, das durch die von der Stromversorgung (16) zwischen der Kathode (12) und der Anode (14) angelegte Hochspannung erzeugt wird, und das magnetische Feld, das von der Magnetfelderzeugungsvorrichtung (18) erzeugt wird, so eingestellt sind, dass eine Leistungsdichte an oder nahe der Oberfläche des Targets (10), insbesondere an einer Außenoberfläche des Targets (10), mindestens 1 kW/cm² beträgt.

8. Magnetron-Sputtervorrichtung (2) nach einem der Ansprüche 1 bis 7, wobei
das Target (10) und die Magnetfelderzeugungsvorrichtung (18) so angeordnet und ausgebildet sind, dass ein Maximalwert einer aktiven Tangentialkomponente einer magnetischen Flussdichte am oder in der Nähe des Außendurchmessers des Targets (10) größer als 40 mT, vorzugsweise größer als 60 mT, am meisten bevorzugt um 80 mT, insbesondere bis zu 120 mT wird.

9. Magnetron-Sputtervorrichtung (2) nach Anspruch 8, wobei
das Target (10) und die Magnetfelderzeugungsvorrichtung (18) so angeordnet und ausgebildet sind, dass eine Axiallänge der aktiven Tangentialkomponente im Bereich des 0,3- bis 0,5-fachen eines Außendurchmessers des Targets (10) liegt, insbesondere im Bereich von 30 bis 50 mm, vorzugsweise 40 mm.

10. Magnetron-Sputtervorrichtung (2) nach einem der Ansprüche 1 bis 9, wobei die Magnetfelderzeugungsvorrichtung (18) aufweist:
ein Paket von drei ringförmigen Magneten (28, 30, 32), vorzugsweise NdFeB-Magneten, die in einer Axialrichtung des Targets (10) angeordnet und durch zwei ringförmige magnetische Stahlplatten (34) getrennt sind, wobei das Paket an einem Kolben (20) befestigt ist, der sich in einer Axialrichtung der Kathode (12) erstreckt und durch den Kolben (20) hin- und herbewegbar ist.

11. Magnetron-Sputtervorrichtung (2) nach Anspruch 10, wobei
die Axiallänge des mittleren Magneten (30) vorzugsweise 2,0 bis 2,5 mal, insbesondere 2,3 mal, größer ist als die Axiallänge jedes der beiden seitlichen Magneten (28, 32); oder
die Axiallänge des mittleren Magneten (30) im Bereich von 25 mm bis 35 mm, vorzugsweise 30 mm, liegt und die Axiallänge jedes der beiden seitlichen Magneten (28, 32) im Bereich von 10 mm bis 15 mm, vorzugsweise 13 mm, liegt; und/oder
die Axiallänge jeder der beiden Stahlplatten (34) vorzugsweise 2,0 bis 3,0 mal, insbesondere 2,6 mal, kleiner als die Axiallänge jedes der beiden seitlichen Magneten (28, 32) ist; oder
die Axiallänge jeder der beiden Stahlplatten (34) im Bereich von 4,0 mm bis 6,0 mm, vorzugsweise 5,0 mm, liegt; und/oder
der Innendurchmesser des ringförmigen Targets (10) 1,5 mal größer als der Außendurchmesser der ringförmigen Magnete (28, 30, 32) ist; oder
der Außendurchmesser des ringförmigen Targets (10) 1,8 bis 2,0 mal größer als der Außendurchmesser der ringförmigen Magnete (28, 30, 32) ist; oder
der Außendurchmesser des ringförmigen Targets (10) 110 mm beträgt, der Innendurchmesser des ringförmigen Targets (10) 90 mm beträgt, der Außendurchmesser der ringförmigen Magnete (28, 30, 32) 60 mm beträgt und der Innendurchmesser der ringförmigen Magnete (28, 30, 32) 23 mm beträgt.

12. Magnetron-Sputtervorrichtung (2) nach einem der Ansprüche 1 bis 11, wobei der Abstand zwischen dem Target (10) und dem zumindest einen Substrat zwischen 2 cm und 15 cm ist.

13. Verfahren zum Betreiben der Magnetron-Sputtervorrichtung nach einem der Ansprüche 1 bis 12, bei dem die Magnetfeldstärke und die Leistungsdichte so gesteuert werden, dass mit einem Titan-Target eine Metallionisierung von mindestens 30% erreicht wird.

14. Verfahren nach Anspruch 13, bei dem die Bewegungsmittel (20) und/oder die Magnetfelderzeugungsvorrichtung (18) so gesteuert werden, dass eine Dicke einer Beschichtung auf dem Substrat entlang seiner Axialabmessung gleichmäßig ist.

## Revendications

1. Appareil de pulvérisation magnétron (2) pour revêtir un substrat, de préférence avec des cibles de pulvérisation à base de AlCr, AlTi, Ti ou ta-C pour une préparation de film mince à base de AlCrN, AlTiN, TiN ou ta-C, comprenant :
une chambre de traitement (4) à évacuer puis à alimenter avec un gaz de pulvérisation (6), tel que Ar, de préférence avec une pression partielle d'Ar de 0,1 Pa à 1 Pa, Xe et/ou N₂, de préférence avec une pression partielle de N₂ de 0,05 Pa à 0,3 Pa ;
des moyens de maintien de substrat (8) pour maintenir le substrat ;
une cathode tubulaire (12), une anode (14) et une alimentation électrique (16) pour appliquer une haute tension, de préférence de 300 V à 1 000 V, entre la cathode et l'anode ;
une cible tubulaire (10) formant la cathode (12) ou étant supportée par la cathode (12), faisant face au substrat et étant soumise à une pulvérisation par plasma formé au sein de la chambre de traitement (4),
un dispositif de génération de champ magnétique formant un champ magnétique de manière à confiner des électrons dans le plasma au niveau ou à proximité d'une surface de la cible (10) ; et
des moyens de déplacement (20) pour déplacer le dispositif de génération de champ magnétique dans une direction axiale de la cible (10), de préférence sur au moins une distance supérieure à la longueur axiale du dispositif de génération de champ magnétique (18), de préférence avec une vitesse dans la plage de 0,1 à 2,0 m/s, plus préférentiellement dans la plage de 0,3 à 1,0 m/s, **caractérisé en ce que**
ledit dispositif de génération de champ magnétique (18) présente un ensemble de trois aimants alignés (28, 30, 32), dans lequel un aimant central (30) est de polarité opposée et magnétiquement plus fort que les aimants latéraux (28, 32), concentrant ainsi le champ magnétique sur une zone mince au niveau de l'aimant central (30) pour permettre, au niveau ou à proximité de la surface cible, la génération de densités de puissance de pic supérieures à 500 W/cm².

2. Appareil de pulvérisation magnétron selon la revendication 1, dans lequel tous les aimants (28, 30, 32) du dispositif de génération de champ magnétique (18) sont constitués du même matériau magnétique, et l'aimant central (30) est plus épais que les aimants latéraux (28, 32).

3. Appareil de pulvérisation magnétron selon la revendication 1, dans lequel l'aimant central (30) est constitué d'un matériau magnétiquement plus résistant que les aimants latéraux (28, 32).

4. Appareil de pulvérisation magnétron (2) selon l'une quelconque des revendications 1 à 3, dans lequel
ladite cible (10) présentant de préférence un diamètre extérieur dans la plage de 80 à 120 mm, de préférence de 105 mm ;
une pluralité de moyens de maintien de substrat (8, 36) sont agencés dans une direction circonférentielle autour de la cible tubulaire (10) ; et
les moyens de déplacement (20) sont configurés pour déplacer le dispositif de génération de champ magnétique à l'intérieur de la cathode tubulaire (12) dans une direction axiale de la cathode tubulaire (12).

5. Appareil de pulvérisation magnétron (2) selon la revendication 4, dans lequel
la cible (10) et la pluralité de moyens de maintien de substrat (8, 36) sont configurés pour tourner les uns par rapport aux autres et/ou chacun de la pluralité de moyens de maintien de substrat est configuré pour faire tourner le substrat autour d'un axe parallèle à l'axe central de la cible (10).

6. Appareil de pulvérisation magnétron (2) selon l'une quelconque des revendications 1 à 5, comprenant en outre :
des moyens de refroidissement (24, 26) pour faire circuler un milieu de refroidissement (22) le long d'une surface intérieure de la cible (10).

7. Appareil de pulvérisation magnétron (2) selon l'une quelconque des revendications 1 à 6, dans lequel le champ électrique formé par la haute tension appliquée par l'alimentation électrique (16) entre la cathode (12) et l'anode (14) et le champ magnétique formé par le dispositif de génération de champ magnétique (18) est réglé de telle sorte qu'une densité de puissance au niveau ou à proximité de la surface de la cible (10), en particulier sur une surface extérieure de la cible (10), soit d'au moins 1 kW/cm².

8. Appareil de pulvérisation magnétron (2) selon l'une quelconque des revendications 1 à 7, dans lequel
la cible (10) et le dispositif de génération de champ magnétique (18) sont agencés et configurés de telle sorte qu'une valeur maximale d'une composante tangentielle active d'une densité de flux magnétique au niveau ou à proximité du diamètre extérieur de la cible (10) devienne supérieure à 40 mT, de préférence supérieure à 60 mT, le plus préférentiellement d'environ 80 mT, en particulier jusqu'à 120 mT.

9. Appareil de pulvérisation magnétron (2) selon la revendication 8, dans lequel
la cible (10) et le dispositif de génération de champ magnétique (18) sont agencés et configurés de telle sorte qu'une longueur axiale de la composante tangentielle active est dans la plage de 0,3 à 0,5 fois un diamètre extérieur de la cible (10), en particulier dans la plage de 30 à 50 mm, de préférence de 40 mm.

10. Appareil de pulvérisation magnétron (2) selon l'une quelconque des revendications 1 à 9, le dispositif de génération de champ magnétique (18) comprenant :
un paquet de trois aimants annulaires (28, 30, 32), de préférence des aimants de NdFeB, agencés dans une direction axiale de la cible (10) et séparés par deux plaques d'acier magnétiques annulaires (34), ledit paquet étant fixé à un piston (20) s'étendant dans une direction axiale de la cathode (12) et pouvant être déplacé par le piston (20) en va-et-vient.

11. Appareil de pulvérisation magnétron (2) selon la revendication 10, dans lequel
la longueur axiale de l'aimant central (30) est de préférence de 2,0 à 2,5 fois, en particulier de 2,3 fois, supérieure à la longueur axiale de chacun des deux aimants latéraux (28, 32) ; ou
la longueur axiale de l'aimant central (30) est dans la plage de 25 mm à 35 mm, de préférence de 30 mm, et la longueur axiale de chacun des deux aimants latéraux (28, 32) est dans la plage de 10 mm à 15 mm, de préférence de 13 mm ; et/ou
la longueur axiale de chacune des deux plaques d'acier (34) est de préférence de 2,0 à 3,0 fois, en particulier de 2,6 fois, inférieure à la longueur axiale de chacun des deux aimants latéraux (28, 32) ; ou
la longueur axiale de chacune des deux plaques d'acier (34) est dans la plage de 4,0 mm à 6,0 mm, de préférence de 5,0 mm ; et/ou
le diamètre intérieur de la cible annulaire (10) est de 1,5 fois supérieur au diamètre extérieur des aimants annulaires (28, 30, 32) ; ou
le diamètre extérieur de la cible annulaire (10) est de 1,8 à 2,0 fois supérieur au diamètre extérieur des aimants annulaires (28, 30, 32) ; ou
le diamètre extérieur de la cible annulaire (10) est de 110 mm, le diamètre intérieur de la cible annulaire (10) est de 90 mm, le diamètre extérieur des aimants annulaires (28, 30, 32) est de 60 mm, et le diamètre intérieur des aimants annulaires (28, 30, 32) est de 23 mm.

12. Appareil de pulvérisation magnétron (2) selon l'une quelconque des revendications 1 à 11, dans lequel la distance entre la cible (10) et le au moins un substrat est de 2 cm à 15 cm.

13. Procédé de fonctionnement de l'appareil de pulvérisation magnétron selon l'une quelconque des revendications 1 à 12, dans lequel l'intensité du champ magnétique et la densité de puissance sont commandées de telle sorte qu'avec une cible en titane, une ionisation métallique d'au moins 30 % soit obtenue.

14. Procédé selon la revendication 13, dans lequel lesdits moyens de déplacement (20) et/ou ledit dispositif de génération de champ magnétique (18) sont commandés de telle sorte qu'une épaisseur d'un revêtement sur le substrat soit uniforme le long de sa dimension axiale.
